# EUROPEAN PATENT APPLICATION

(11) **EP 4 770 411 A1**
(43) Date of publication of application: **01.07.2026**
(21) Application number: 25214888.7
(22) Date of filing: 11.11.2025
(51) Int. Cl.: H10W 70/63, H10W 70/685, H10W 70/692

(54) **POLYMER THROUGH GLASS VIA BUFFER LAYERS IN GLASS CORE SUBSTRATES**

(30) Priority: 24.12.2024 US 202419000995
(71) Applicant: INTEL Corporation, Santa Clara, CA 95054 (US)
(72) Inventor: SAEEDIFARD, Farzaneh, Chandler, AZ 85226 (US); KANG, Zheng, Chandler, AZ 85249 (US); LTEIF, Sandrine, Phoenix, AZ 85048 (US); NARUTE, Suresh T., Chandler, AZ 85224 (US); CHO, Steve S., Chandler, AZ 85226 (US); DUAN, Gang, Chandler, AZ 85248 (US); GRUJICIC, Darko, Chandler, AZ 85249 (US); HEATON, Thomas S., Gilbert, AZ 85234 (US); JIN, Lei, Chandler, AZ 85226 (US); KANDANUR, Sashi Shekhar, Chandler, AZ 85226 (US); KAVIANI, Shayan, Phoenix, AZ 85044 (US); KIM, Kihyun, Chandler, AZ 85286 (US); LEHAF, Ali, Chandler, AZ 85226 (US); LI, Yi, Chandler, AZ 85225 (US); MOHAMMADIGHALENI, Mahdi, Phoenix, AZ 85048 (US); NDUKUM, Tchefor T., Chandler, AZ 85286 (US); PIETAMBARAM, Srinivas Venkata Ramanuja, Chandler, AZ 95249 (US); TAVAKOLI, Elham, Phoenix, AZ 85048 (US); WALL, Marcel A., Phoenix, AZ 85048 (US); ZAMANI, Ehsan, Phoenix, AZ 85048 (US)
(74) Representative: HGF

(57) **Abstract**

In one embodiment, a substrate includes a glass core layer with conductive through glass vias (TGVs). The substrate also includes a polymer layer between the glass core layer and the TGVs.

## Description

### BACKGROUND

Continued growth in computing and mobile devices will continue to increase the demand for greater bandwidth density within and reliability of semiconductor packages. Some integrated circuit packages may implement glass cores, which can provide advantages over traditional packages with organic material cores (e.g., glass cores are thicker and can better resist warpage through the manufacturing process). Through Glass Vias (TGVs) can provide electrical connections through the glass core, e.g., to connect metallization layers on either side of the glass core.

### BRIEF DESCRIPTION OF THE DRAWINGS

FIG. 1 illustrates an example substrate with a glass core exhibiting stress cracks.
FIGS. 2A-2B illustrate example substrates implementing polymer TGV buffer layers between a glass core and through glass vias (TGVs) in accordance with embodiments of the present disclosure.
FIGS. 3A-3H illustrate an example process of fabricating a glass core substrate having a polymer TGV buffer layer in accordance with embodiments of the present disclosure.
FIGS. 4A-4G illustrate another example process of fabricating a glass core substrate having a polymer TGV buffer layer in accordance with embodiments of the present disclosure.
FIGS. 5A-5C illustrate an example process of forming a polymer TGV buffer layer on a glass substrate in accordance with some embodiments of the present disclosure.
FIGS. 6A-6B illustrate another example process of forming a polymer TGV buffer layer on a glass substrate in accordance with some embodiments of the present disclosure.
FIG. 7 illustrates an example package substrate with a glass core having polymer TGV buffer layers in accordance with embodiments herein.
FIG. 8 illustrates an example multi-die package with a glass core having polymer TGV buffer layers in accordance with embodiments herein.
FIG. 9 illustrates another example multi-die package with a glass core having polymer TGV buffer layers in accordance with embodiments herein.
FIGS. 10A-10B illustrate example systems that may incorporate the glass core architectures described herein.
FIG. 11 is a top view of a wafer and dies that may be included in a microelectronic assembly, in accordance with any of the embodiments disclosed herein.
FIG. 12 is a cross-sectional side view of an integrated circuit device that may be included in a microelectronic assembly, in accordance with any of the embodiments disclosed herein.
FIG. 13 is a block diagram of an example electrical device that may include a microelectronic assembly, in accordance with any of the embodiments disclosed herein.

### DETAILED DESCRIPTION

Integrated circuit apparatuses continue to shrink in size, and with this shrinkage, improving device performance has been focused in two directions (1) to achieve chip stacking using thinned chips, and (2) increasing input/output (I/O) density in the substrate for multichip integration. Manufacturing these ever-increasing apparatuses has been made possible with a rigid carrier wafer, such as a glass-based core wafer, in a temporary bonding and debonding technology. However, one of the challenges associated with the temporary bonding and debonding technology is the warpage or shrinkage control after removal of the rigid carrier. Once the rigid glass carrier is de-bonded after bump formation, the substrate might be expected to warp due to inbuilt residual stress and CTE (coefficient of thermal efficiency) mismatch between various components, e.g., between Silicon (2.6 ppm/°C), ABF (~39 ppm/°C) and Copper (17 ppm/°C). This can impact the back-end process for bump formation and the assembly process.

One way to address the above problem is to use glass or a glass-based material as a permanent substrate core, as glass is stiffer than organic core materials. For example, glass may have a modulus of elasticity of ~ 60-90 GPa as compared with a modulus of elasticity ~25- 30 GPa for organic core materials. A permanent glass core can restrict warpage and may thereby maintain TTV requirements for smaller pitch scaling. Through glass vias (TGVs) provide electrical connections through the glass core substrate, e.g., to provide electrical connections between metallization layer on either side of the core. Current TGVs may be implemented as fully plated TGVs, where the through hole in the glass core is completely filled with plated metal (e.g., copper), after a seed layer has been deposited (e.g., by sputtering). Fully plated TGVs, however, can suffer from thermomechanical stress-related challenges due to the large volume of copper and the large CTE mismatch between copper and glass. More particularly, the large CTE mismatch between plated copper and glass results in radial stress upon heating and tensile stress upon cooling, which can cause stress cracks or other issues in the glass core.

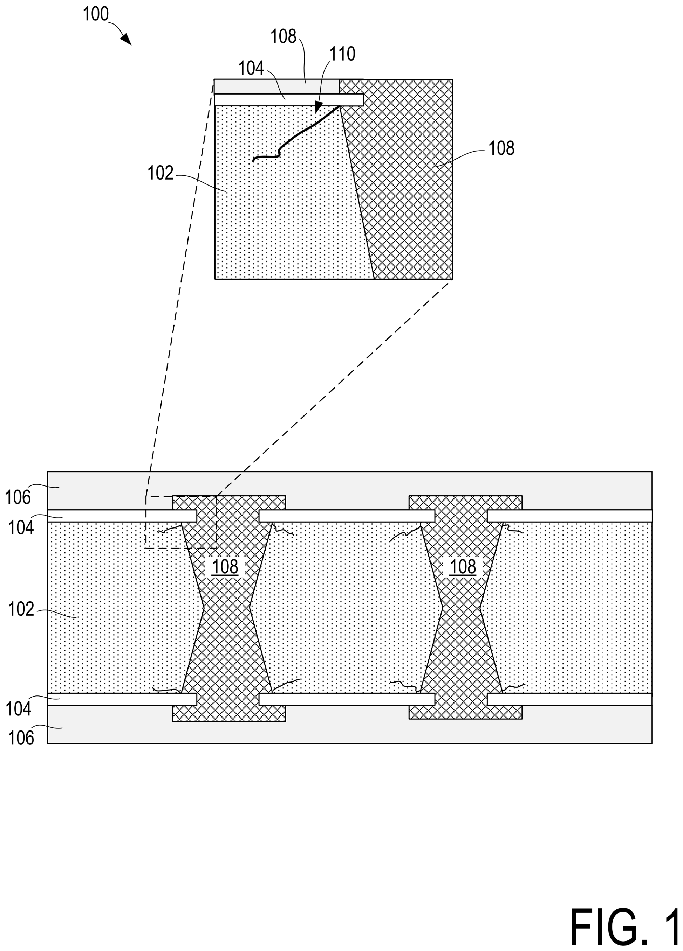

FIG. 1 illustrates an example substrate 100 with a glass core layer 102 exhibiting stress cracks 110. In particular, FIG. 1 illustrates a side cross-sectional view showing through glass vias (TGVs) 108 in the substrate 100. The TGVs 108 may be formed of metal (e.g., Copper) and are formed in a glass core layer 102 of the substrate 100, which may form the core layer of an integrated circuit package substrate as described further below. The TGVs 108 extend from a top surface of the glass core layer 102 to a bottom surface of the glass core layer 102 as shown. The glass core layer 102 may include glass or a glass-based material. In certain embodiments, the glass core layer 102 may include Silicon (e.g., at least 23% by weight) and Oxygen (e.g., at least 26% by weight). The glass core layer 102 may be amorphous, and in some embodiments, may include one or more additive elements (e.g., at least 5% by weight) such as Aluminum, Boron, Magnesium, Calcium, Barium, Tin, Sodium, Potassium, Strontium, Phosphorus, Zirconium, Lithium, Titanium, and Zinc. For example, the glass core layer 102 may be formed of one or more of the following example materials: aluminosilicate, borosilicate, alumino-borosilicate, silica, or fused silica. In some embodiments, the glass core layer 102 may further include one or more additives, such as, for example, Al₂O₃, B₂O₃, MgO, CaO, SrO, BaO, SnO₂, Na₂O, K2O, SrO, P₂O₃, ZrO₂, Li₂O, Ti, and Zn. In some embodiments, the glass core layer 102 may be made of a spin-on glass (SOG) material.

The substrate 100 includes TGV buffer layers 104 on each of the top and bottom surfaces of the glass core layer 102 as shown. The TGV buffer layers 104 may include one or more of SiOₓ, SiNₓ, or carbon-doped SiOₓ, and may be deposited by physical or chemical vapor deposition methods. The substrate 100 further includes buildup dielectric layers 106 on the TGV buffer layers 104 as shown, which may be formed of organic buildup dielectric materials, e.g., Ajinomoto Build-Up Film (ABF).

In some cases, stress cracks (e.g., 110) may form near the areas in which the glass core material, TGV material, and buffer layer material meet. This area may be a particularly high stress region that is prone to cracking during thermal treatments or high temperature processes that substrates may see during their manufacturing, and this may be based on mismatches between the coefficients of thermal expansion between each of the three materials.

Embodiments herein may address these or other issues by including an organic, flexible polymer buffer layer between the glass core layer and TGVs within the glass core layer. This may mitigate the stress on the glass core during high temperature processes, enabling higher yields of glass core substrates for integrated circuit packages or other applications. For example, some embodiments may include a layer of polymer with a low Young's modulus, e.g., polypyrrole, polythiophene, polyaniline, PEDOT (poly(3,4-ehtylenedioxythiophene) polymer), PEDOT:PSS (a mixture or composite of PEDOT and polystyrene sulfonate (PSS)), polyamine, other thiophene-based polymers, pyrrole-based polymers, aniline-based polymers, or other low Young's modulus materials as described herein, which can avoid stress cracks/propagation.

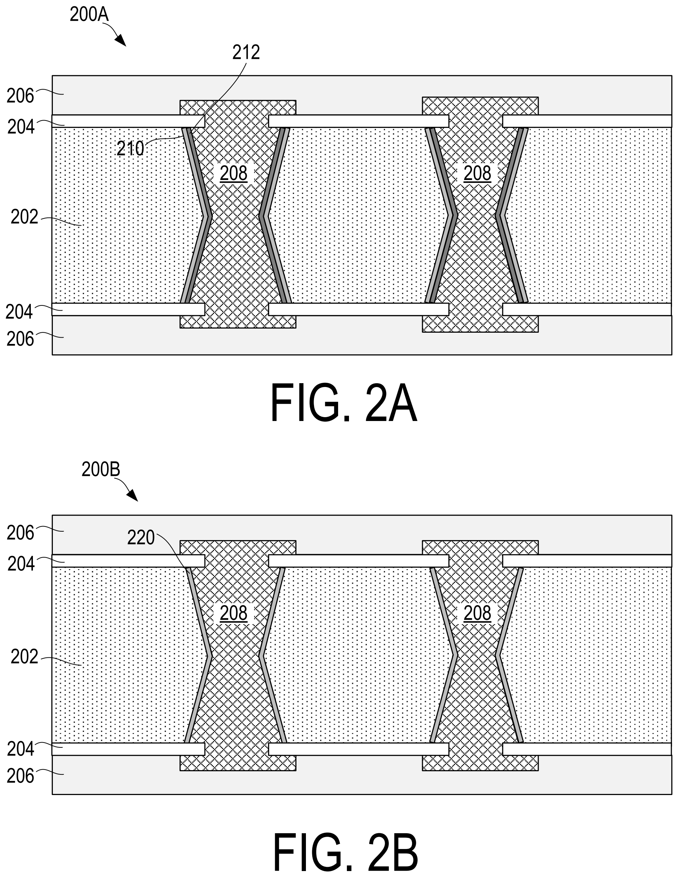

FIGS. 2A-2B illustrate example substrates 200A, 200B implementing polymer TGV buffer layers 212, 220 between a glass core 202 and through-glass vias (TGVs) 208 in accordance with embodiments of the present disclosure. More particularly, the substrate 200A of FIG. 2A includes a glass core 202 with TGVs 208 through the glass core 202. Each example substrate includes a glass core 202 with buffer layers 204 on the top and bottom surfaces of the glass core 202 as shown, and further includes buildup dielectric layers 206 on the buffer layers 204. In some embodiments, the buffer layers 204 may include dielectric material, e.g., SiNₓ, SiOₓ or another type of dielectric material. In some embodiments, the buffer layers 204 may include conductive materials, e.g., conductive seed materials such as copper or other metals. The substrates may include additional layers, e.g., additional buildup layers and/or metallization layers as described in certain examples below.

The example substrate 200A of FIG. 2A includes an intermediate layer 210 and a polymer buffer layer 212 between the glass core 202 and the TGVs 208 as shown, while the example substrate 200B of FIG. 2B includes a polymer buffer layer directly between the glass core 202 and the TGVs 208. The polymer buffer layers may be formed are described in the examples below or in other suitable manners. As shown in each example, the metal of the TGVs 208 is not in direct contact with the glass core 202 because of the presence of the polymer layers, which may be a relatively flexible material with a low Young's modulus, avoiding stress on the glass core 202 and thus avoiding stress cracks that may form without such buffer layers in place.

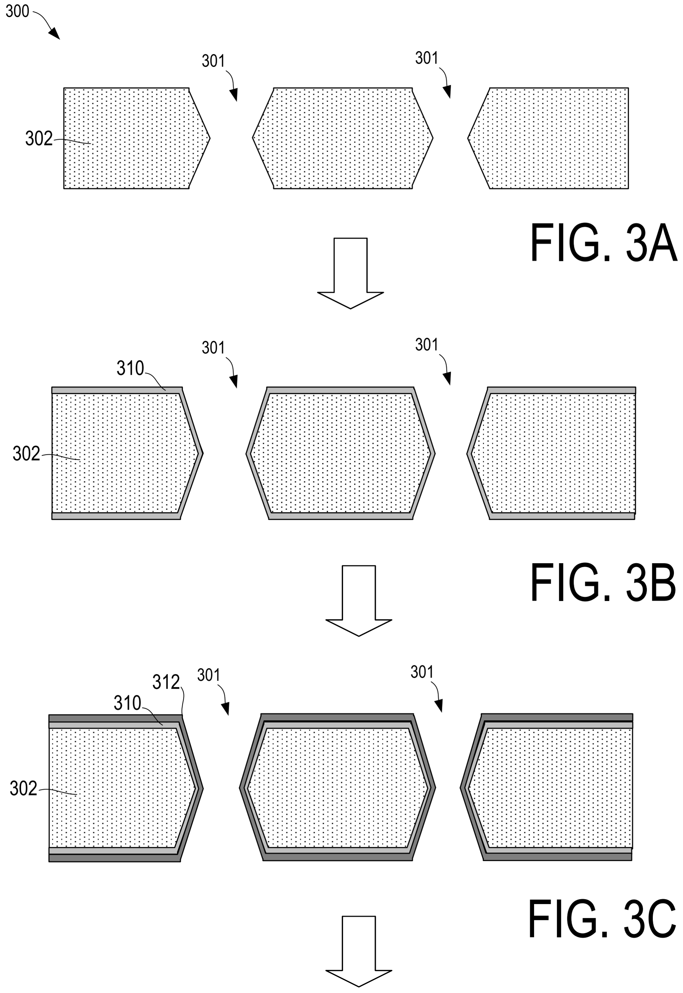

FIGS. 3A-3H illustrate an example process 300 of fabricating a glass core substrate having a polymer buffer layer in accordance with embodiments of the present disclosure. The example process shown may include additional, fewer, or different operations than those shown or described below. In some embodiments, one or more of the operations shown or described include multiple operations, sub-operations, etc. The illustrations of FIGS. 3A-3H may accordingly represent different stages in the manufacturing process of a device, e.g., an integrated circuit package substrate. Although the process 300 is illustrated with respect to two TGVs in a glass core substrate, it will be understood that the process 300 can be used in glass core substrates with any number of TGVs.

Referring to FIG. 3A, the process 300 begins by forming holes 301 in a glass core layer 302 as shown. The holes 301 may be formed via laser drilling, a wet etch process, or other suitable techniques. Then, as shown in FIGS. 3B-3C, an adhesion layer 310 is formed on the surfaces of the glass core layer 302 and then a polymer material layer 312 is formed on the adhesion layer 310.

In some embodiments, the adhesion layer 310 is a seed layer formed from a conductive material, e.g., a metal such as copper or silver, that is deposited using atomic layer deposition (ALD). The polymer material layer 312 may include an organic, conductive polymer material, such as, for example, polypyrrole (which includes carbon and nitrogen), polythiophene (which includes carbon and sulfur), or polyaniline (which includes carbon and nitrogen). Where the adhesion layer 310 includes a metal, the conductive polymer material layer 312 may be deposited onto the layer 310 by electroplating.

In other embodiments, the adhesion layer 310 may include an oxide or nitride dielectric material (e.g., AlOₓ, ZnOₓ, AlNₓ, or TiOₓ) that is deposited using atomic layer deposition (ALD), for example. In such embodiments, the polymer material layer 312 may include an organic polymer material, such as, for example, PEDOT:PSS (which includes carbon, sulfur, and oxygen), and the polymer material layer 312 may be deposited in liquid phase or by chemical vapor deposition (CVD) onto the oxide/nitride adhesion layer 310.

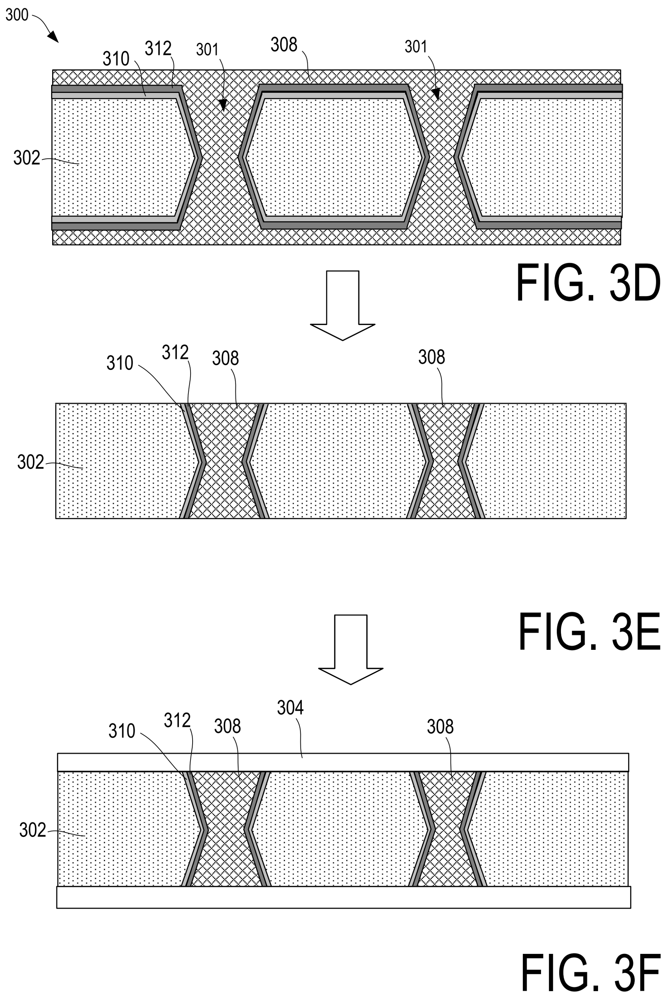

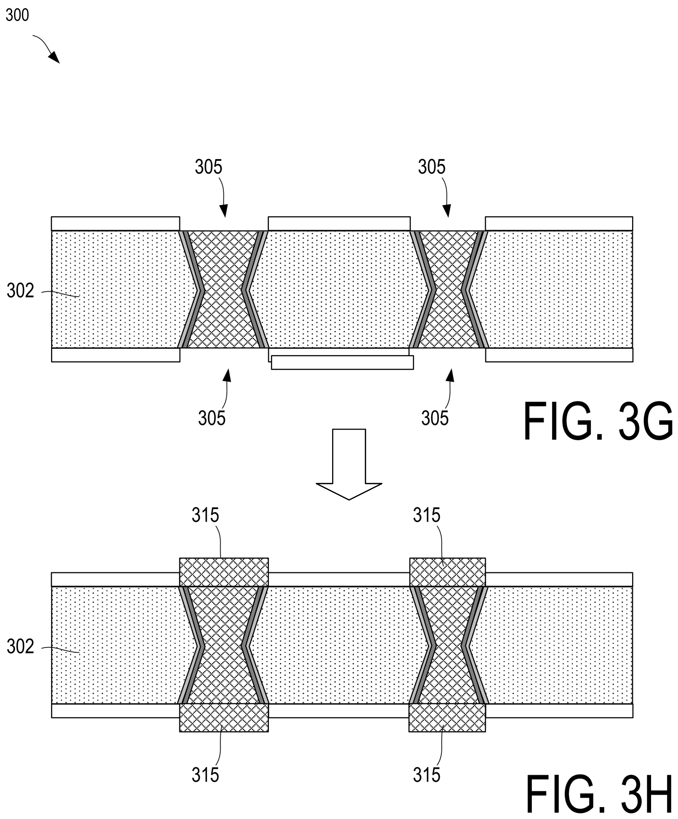

After the polymer material layer 312 has been formed, metal 308 may be formed inside the holes 301 and on the top/bottom surfaces of the layers as shown in FIG. 3D. In some cases, this may include an initial formation of a seed layer and then growth of the metal 308. Then, as shown in FIG. 3E, the top and bottom surfaces may be ground or polished (e.g., by chemical mechanical polishing (CMP)) to remove portions of the metal 308, the polymer material layer 312, and the adhesion layer 310 on the top and bottom surfaces of the glass core layer 302. Buffer layers 304 may then be formed on the top and bottom surfaces of the glass core layer 302 as shown in FIG. 3F. Holes 305 may then be formed in the buffer layer 304 above and below the TGVs as shown in FIG. 3G, and the holes 305 may then be filled in with metal 315 as shown in FIG. 3H to form connections to the TGVs. Buildup and/or metallization layers may then be formed on each side of the substrate, as desired.

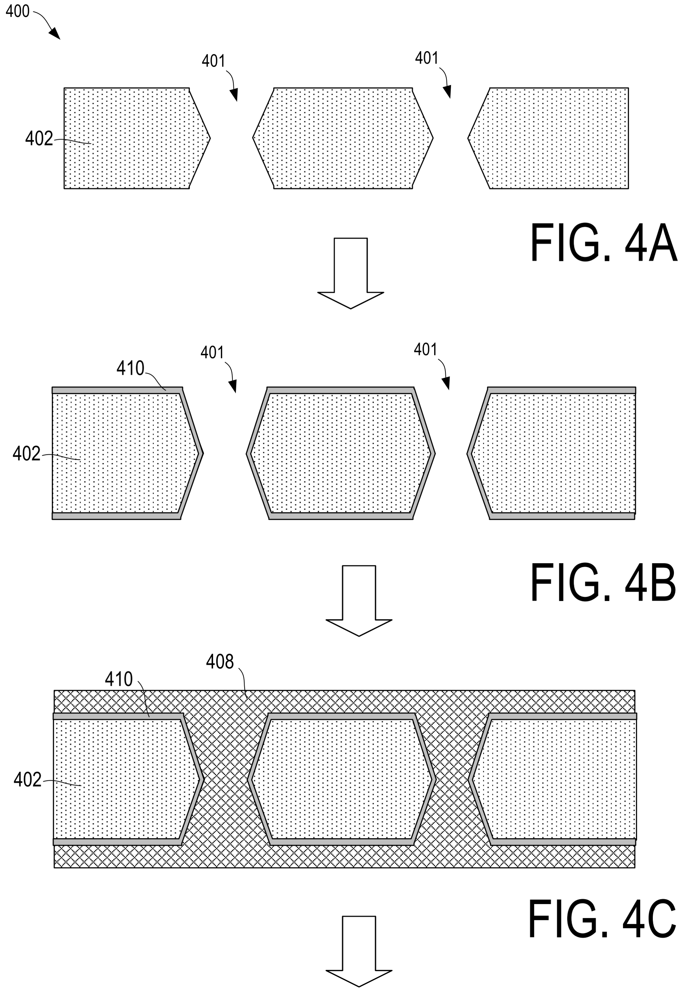

FIGS. 4A-4G illustrate another example process 400 of fabricating a glass core substrate having a polymer buffer layer in accordance with embodiments of the present disclosure. The example process shown may include additional, fewer, or different operations than those shown or described below. In some embodiments, one or more of the operations shown or described include multiple operations, sub-operations, etc. The illustrations of FIGS. 4A-4B may accordingly represent different stages in the manufacturing process of a device, e.g., an integrated circuit package substrate. Although the process 400 is illustrated with respect to two TGVs in a glass core substrate, it will be understood that the process 400 can be used in glass core substrates with any number of TGVs.

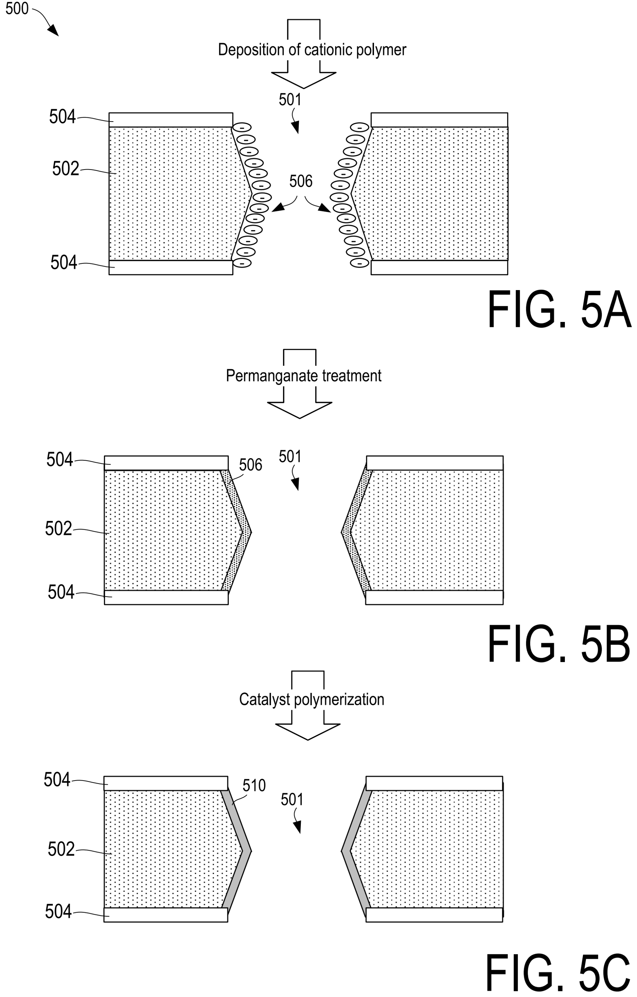

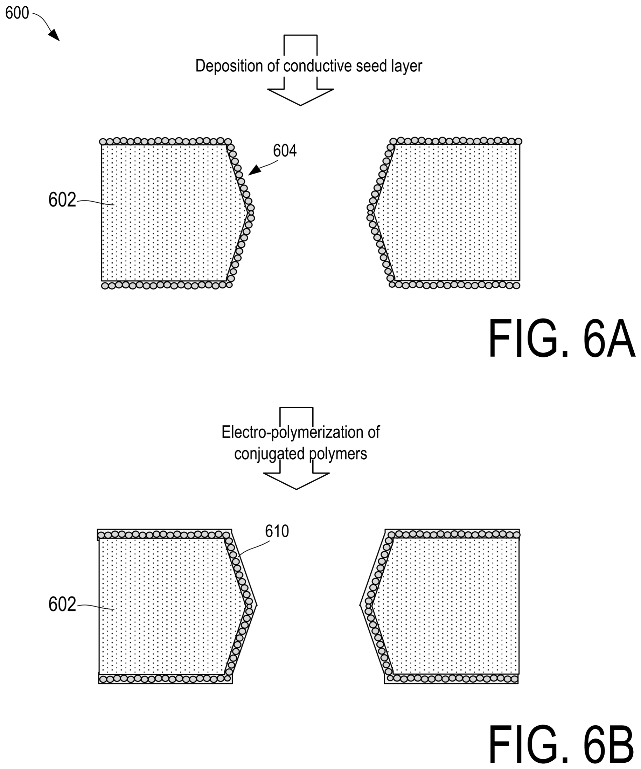

Referring to FIG. 4A, the process 400 begins by forming holes 401 in a glass core layer 402 as shown. The holes 401 may be formed via laser drilling, a wet etch process, or other suitable techniques. Then, as shown in FIG. 4B, a polymer material layer 410 is formed on the surfaces of the glass core layer 402. In some embodiments, the polymer material layer 410 includes an organic, conductive polymer material, such as, for example, PEDOT. The polymer material layer 410 may be deposited onto the glass core layer 402 via molecular layer deposition (MLD) (e.g., oxidative MLD) in certain embodiments, which may, in certain cases, allow for direct deposition onto the glass core layer 402 without a conductive seed layer as in the previous example. For example, a PEDOT layer may be formed on the glass core layer 402 by depositing 3,4-ethylenedioxythiophene (EDT) monomer in the presence of oxidizers, such as, for example, MoCl₅, ReCL₅, or SbCl₅. In other embodiments, the polymer material layer 410 is formed via the processes described below with respect to FIGS. 5A-5C and 6A-6B.

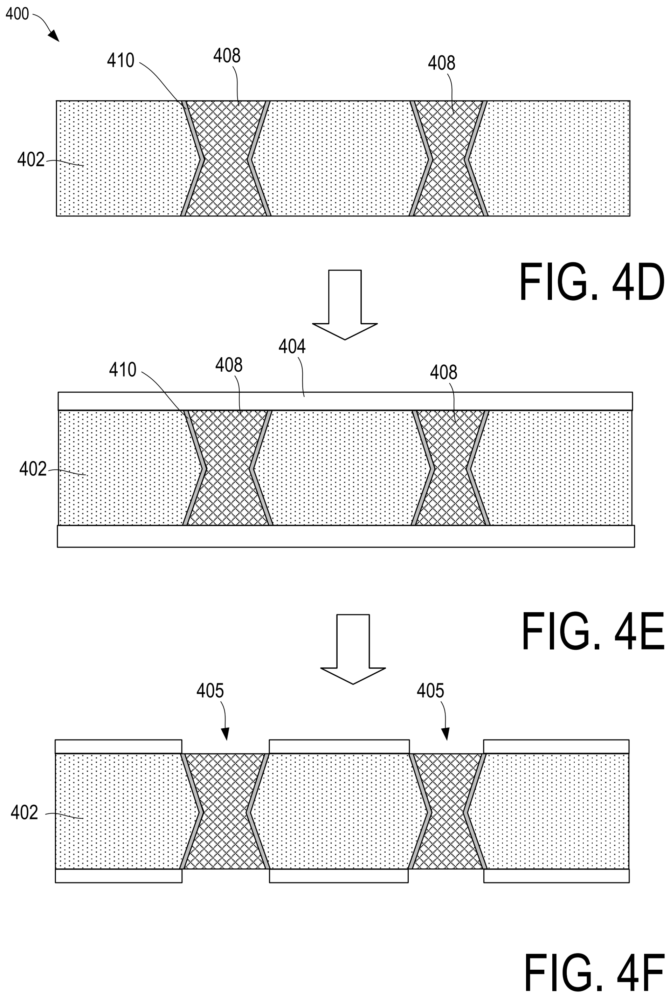

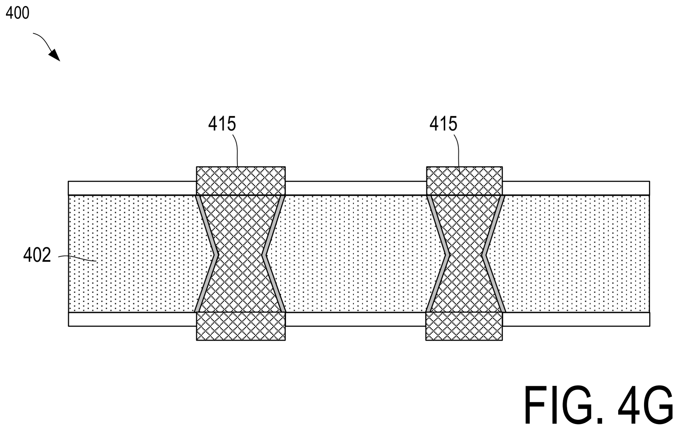

After the polymer material layer 410 has been formed, metal 408 may be formed inside the holes 401 and on the top/bottom surfaces of the layers as shown in FIG. 4C. Then, as shown in FIG. 4D, the top and bottom surfaces may be ground or polished (e.g., by chemical mechanical polishing (CMP)) to remove portions of the metal 408, the polymer material layer 410, and the seed layer 410 on the top and bottom surfaces of the glass core layer 402. Buffer layers 404 may then be formed on the top and bottom surfaces of the glass core layer 402 as shown in FIG. 4E. Holes 405 may then be formed in the buffer layer 404 above and below the TGVs as shown in FIG. 4F, and the holes 405 may then be filled in with metal 415 as shown in FIG. 4G to form connections to the TGVs. Buildup and/or metallization layers may then be formed on each side of the substrate, as desired.

FIGS. 5A-5C illustrate an example process 500 of forming a polymer buffer layer on a glass substrate in accordance with some embodiments of the present disclosure. The example process shown may include additional, fewer, or different operations than those shown or described below. In some embodiments, one or more of the operations shown or described include multiple operations, sub-operations, etc. Although the process 500 is illustrated with respect to a single TGVs in a glass core substrate, it will be understood that the process 500 can be used in glass core substrates with any number of TGVs. In some cases, the process 500 may be considered as operations performed within the process 400 described above, e.g., with respect to forming the polymer layer 410.

Referring to FIG. 5A, the inner surfaces of a hole 501 within a glass core layer 502 are preconditioned by depositing a conductive cationic polymer 506, e.g., polyamine. In some embodiments, the top and bottom surfaces of the glass core layer 502 may have a conductive seed layer 504 deposited thereon as shown. Then, as shown in FIG. 5B, a permanganate (MnO⁻₄) treatment is applied to the conductive cationic polymer, which allows MnO₂ to get absorbed on the inner walls of the holes 501. Then, as shown in FIG. 5C, an EDT monomer is deposited onto the conductive cationic polymer (e.g., by spraying the monomer) and the polymer is oxidized in the presence of PSS to result in the formation of a thin conductive polymer layer 510, which may be PEDOT:PSS in certain embodiments. The PSS may donate H+ ions, making the layer 510 conductive.

FIGS. 6A-6B illustrate another example process 600 of forming a polymer buffer layer on a glass substrate in accordance with some embodiments of the present disclosure. The example process shown may include additional, fewer, or different operations than those shown or described below. In some embodiments, one or more of the operations shown or described include multiple operations, sub-operations, etc. Although the process 500 is illustrated with respect to a single TGVs in a glass core substrate, it will be understood that the process 500 can be used in glass core substrates with any number of TGVs. In some cases, the process 600 may be considered as operations performed within the process 300 described above, e.g., with respect to forming the layers 310, 312.

Referring to FIG. 6A, a conductive seed layer 604 is deposited onto the surfaces of a glass core layer 602 as shown. In certain embodiments, the conductive seed layer 604 may be a metal, e.g., Silver or Copper, that is deposited using ALD, or another conductive material (e.g., a polymer material with high conductivity). In some embodiments, the conductive seed layer 604 may be deposited in a non-conformal manner. Then, as shown in FIG. 6B, a layer of organic polymer material 610 is deposited onto the seed layer 604 and electro-polymerization is performed. The electro-polymerization may be performed using potentiostat, galvanostat, or cyclic voltammetry in certain embodiments. The polymer material 610 may fill in gaps left from the seed layer 604 and may provide one or more advantages described above, e.g., prevention of stress crack formation in the glass core layer 602. The seed layer 604 may be used as a working electrode for the electro-polymerization process, and also enhances the conductivity of the resulting buffer layer. A variety of organic materials may be used as the polymer material 610, e.g., thiophene-based polymers, pyrrole-based polymers, aniline-based polymers, functionalized conjugated materials with tunable work function, hydrophobicity two-dimensional conjugated materials, or covalent organic frameworks (COFs). The thickness and properties of the resulting polymer buffer layer can be controlled by adjusting one or more of the concentration of the solution, the thickness of the depositing organic layer, the time of the electro-polymerization process, type of electro-polymerization used. This process may be cost effective compared to techniques that rely on vapor deposition (dry processes) and may provide higher throughput compared to dry processes as well.

The polymeric buffer layers described herein may provide low modulus values that may act as a stress buffer layer to prevent damage to TGVs of glass core substrates. The techniques described herein provide simple and cost-effective methods for forming such stress buffer layers in high aspect ratio structures like TGVs, but also blind vias or trenches as well.

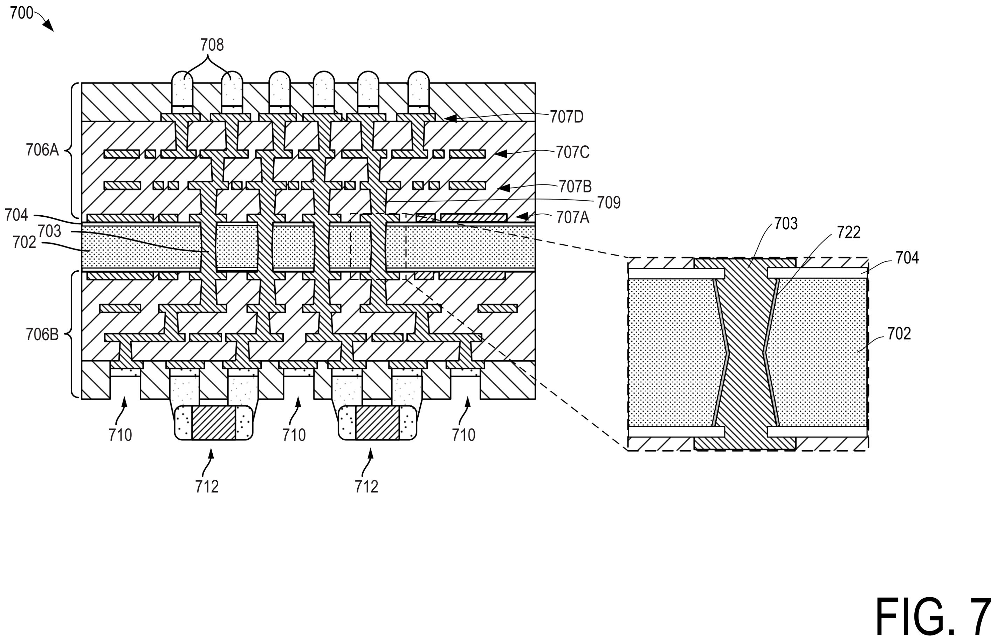

FIG. 7 illustrates an example package substrate 700 with a glass core 702 having polymer TGV buffer layers in accordance with embodiments herein. The glass core 702 may include Silicon (e.g., at least 23% by weight) and Oxygen (e.g., at least 26% by weight). The glass core layer 102 may be amorphous, and in some embodiments, may include one or more additive elements (e.g., at least 5% by weight) such as Aluminum, Boron, Magnesium, Calcium, Barium, Tin, Sodium, Potassium, Strontium, Phosphorus, Zirconium, Lithium, Titanium, and Zinc. For example, the glass core 702 may be formed of one or more of the following example materials: aluminosilicate, borosilicate, alumino-borosilicate, silica, or fused silica. In some embodiments, the glass core 702 may further include one or more additives, such as, for example, Al₂O₃, B₂O₃, MgO, CaO, SrO, BaO, SnO₂, Na₂O, K2O, SrO, P₂O₃, ZrO₂, Li₂O, Ti, and Zn. In some embodiments, the glass core 702 may be made of a spin-on glass (SOG) material.

As shown, the substrate 700 includes a polymer layer 722 between the glass core 702 and the TGVs 703 in the glass core 702. The polymer layer 722 may be formed in accordance with embodiments of the present disclosure, e.g., those described above. Although not illustrated, in some embodiments, the substrate 700 may also include a seed layer between the glass core 702 and the polymer layer 722, similar to the intermediate layer 210 of FIG. 2A and layer 310 of FIGS. 3A-3H.

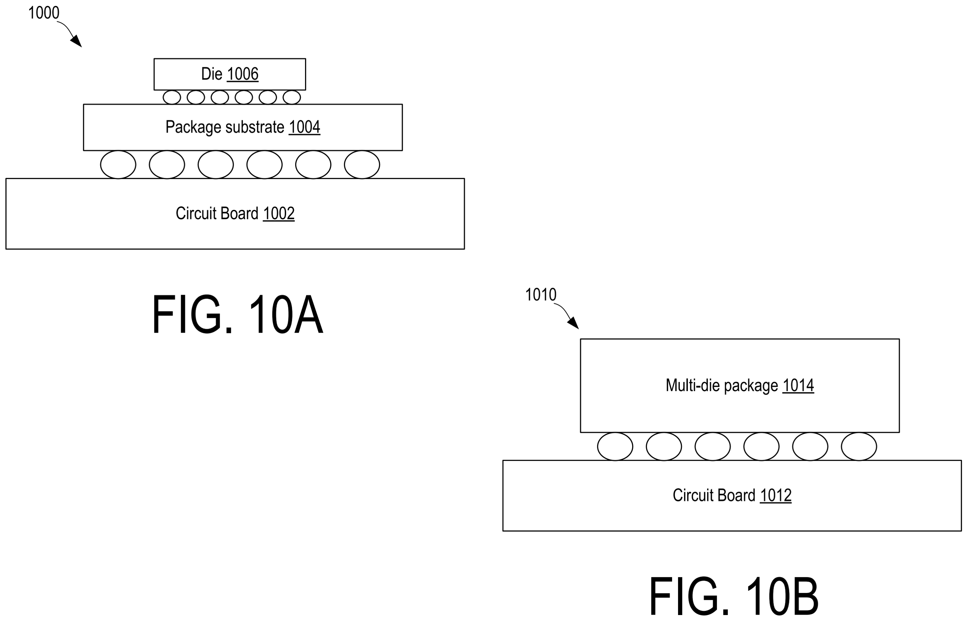

The substrate 700 also includes a dielectric layer 704 on its top and bottom surfaces, between the glass core 702 and buildup layers 706A, 706B. The buildup layers 706A, 706B are formed on the top and bottom sides of the glass core 702, with buildup layers 706A on the top side of the glass core 702 and the buildup layers 706B on bottom side of the glass core 702. The buildup layers 706 include metallization layers (e.g., 707A-D) connected by vias (e.g., 709), which, together with the TGVs 703, electrically couple the solder bumps 708 at the top of the package substrate 700 with the pads 710 at the bottom of the substrate. In certain instances, for example, an integrated circuit die may be coupled to a top side of the package substrate 700 and connect to the solder bumps 708, and the package substrate 700 may be coupled to a circuit board (e.g., a motherboard, main board, etc.) via the pads 710 at the bottom of the package substrate 700. For instance, the package substrate 700 may be incorporated into the system 1000 of FIG. 10A as the package substrate 1004. The package substrate 700 also includes land side capacitors 712 coupled on a bottom side of the package substrate 700.

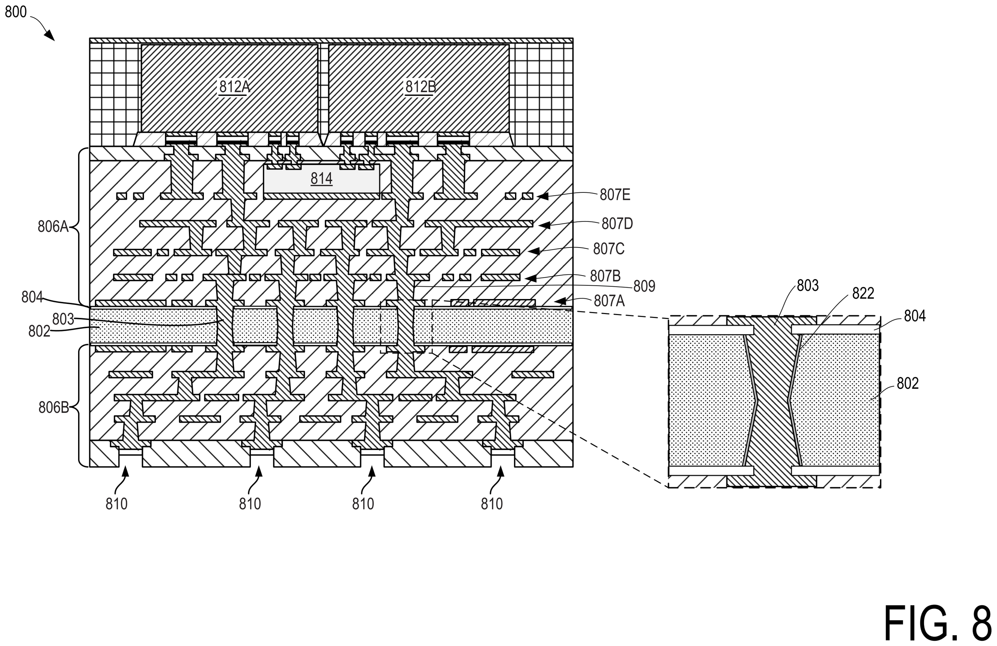

FIG. 8 illustrates an example multi-die package 800 with a glass core 802 having polymer TGV buffer layers in accordance with embodiments herein. The glass core 802 may be similar to the glass core 702. The package 800 also includes a dielectric layer 804 on the top and bottom sides of the glass core 802 and a polymer layer 822 between the TGVs 803 and the glass core 802. The polymer layer 822 may be formed similar to the polymer layer 722, i.e., in accordance with embodiments herein. Further, although not illustrated, in some embodiments, the package 800 may also include a seed layer between the glass core 802 and the polymer layer 822, similar to the intermediate layer 210 of FIG. 2A and layer 310 of FIGS. 3A-3H.

The package 800 further includes buildup layers 806A, 806B formed on the top and bottom sides of the glass core 802, with buildup layers 806A formed on the top side of the glass core 802 and the buildup layers 806B formed on bottom side of the glass core 802. The buildup layers 806A, 806B include metallization layers (e.g., 807A-E) connected by vias (e.g., 809) similar to the example described above, which, together with the TGVs 803, electrically couple the integrated circuit (IC) dies 812A, 812B at the top of the multi-die package 800 with the pads 810 at the bottom of the package 800.

In addition, the package 800 includes a bridge circuitry component 814 located in the buildup layers 806A that electrically couples the first IC die 812A with the second IC die 812B. The bridge circuitry component 814 may include passive and/or active components to interconnect the IC dies 812A, 812B. The bridge circuitry component 814 may be an Intel^{®} embedded multi-die interconnect bridge (EMIB) in certain embodiments. In certain instances, the multi-die package 800 may be coupled to a circuit board (e.g., a motherboard, main board, etc.) via the pads 810 at the bottom of the package 800. For instance, the package 800 may be incorporated into the system 1010 of FIG. 10B as the multi-die package 1014.

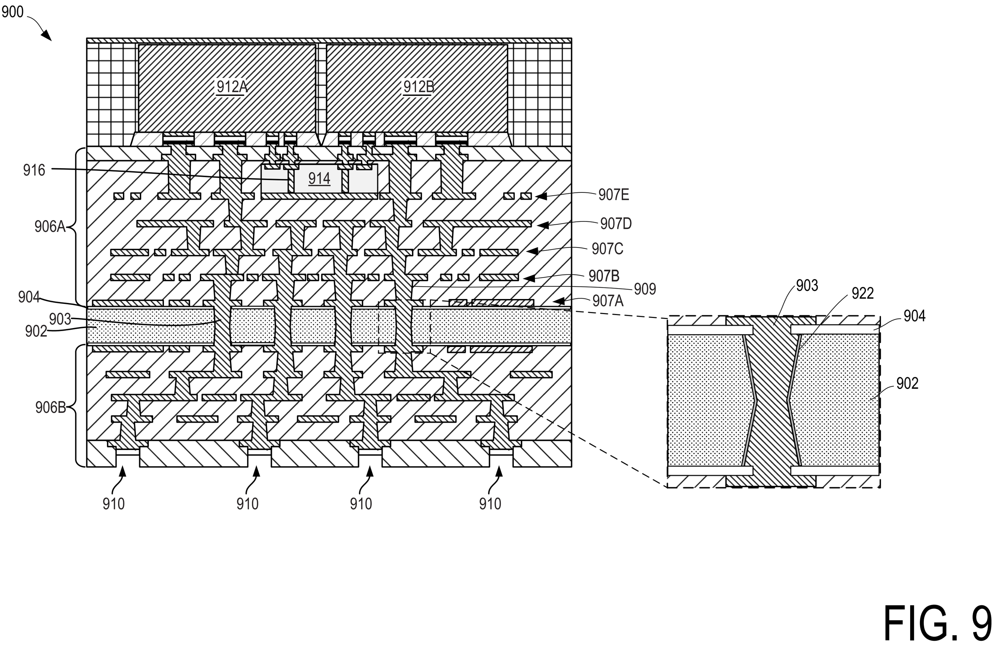

FIG. 9 illustrates another example multi-die package 900 with a glass core 902 having polymer TGV buffer layers in accordance with embodiments herein. The glass core 902 may be similar to the glass core 702 or glass core 802. The package 900 also includes a dielectric layer 904 on the top and bottom sides of the glass core 902 and a polymer layer 922 between the TGVs 903 and the glass core 902. The polymer layer 922 may be formed similar to the polymer layers 722 and 822, i.e., in accordance with embodiments herein. Further, although not illustrated, in some embodiments, the package 900 may also include a seed layer between the glass core 902 and the polymer layer 922, similar to the intermediate layer 210 of FIG. 2A and layer 310 of FIGS. 3A-3H.

The multi-die package 900 further includes buildup layers 906A, 906B formed on the top and bottom sides of the glass core 902, with buildup layers 906A formed on the top side of the glass core 902 and the buildup layers 906B formed on bottom side of the glass core 902. The layers 906A, 906B include metallization layers (e.g., 907A-E) connected by vias (e.g., 909), which, together with the TGVs 903, electrically couple the integrated circuit (IC) dies 912A, 912B at the top of the multi-die package 900 with the pads 910 at the bottom of the package 900.

The multi-die package 900 also includes a bridge circuitry component 914 similar to the bridge circuitry component 814 of the multi-die package 800; however, the bridge circuitry component 914 includes vias 916 from a top surface of the bridge circuitry component 914 to the bottom surface of the bridge circuitry component 914. The vias 916 may connect the IC dies 912A, 912B to certain traces, pillars, etc. within the buildup layers 906A. The bridge circuitry component 914 may be an Intel^{®} embedded multi-die interconnect bridge with TSVs (EMIB-T) in certain embodiments. In certain instances, the multi-die package 900 may be coupled to a circuit board (e.g., a motherboard, main board, etc.) via the pads 910 at the bottom of the package 900. For instance, the package 900 may be incorporated into the system 1010 of FIG. 10B as the multi-die package 1014.

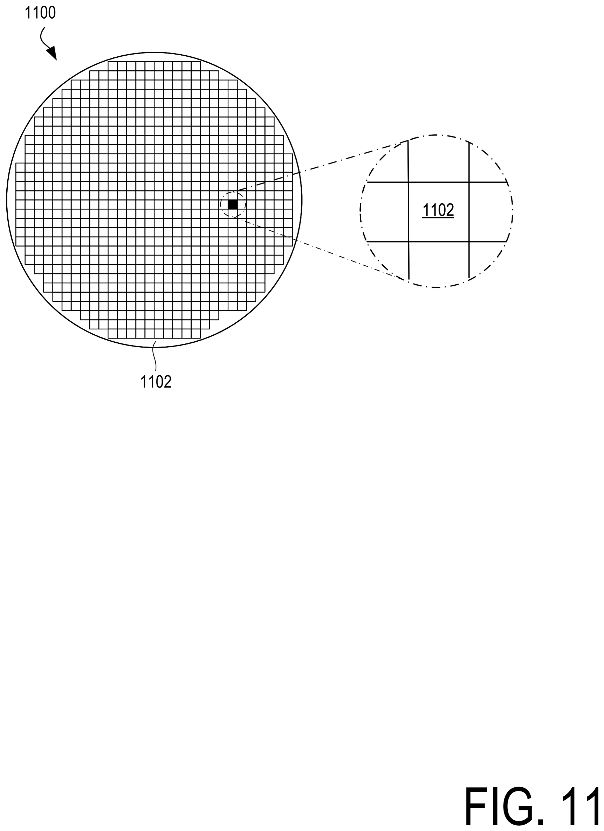

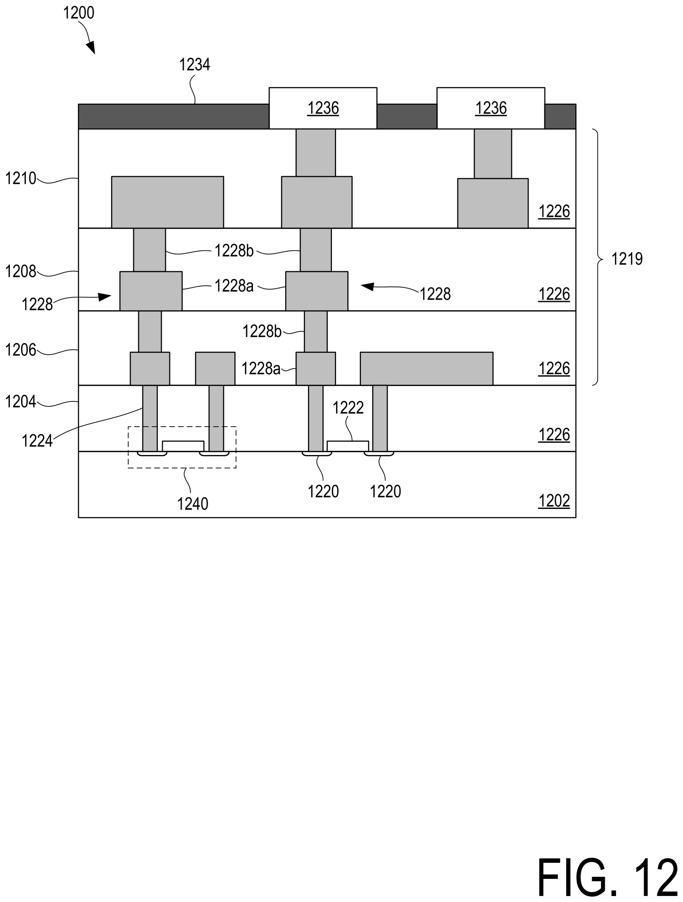

FIGS. 10A-10B illustrate example systems 1000, 1010 that may incorporate the glass core architectures described herein. The example system 1000 of FIG. 10A includes a circuit board 1002, which may be implemented as a motherboard or main board of a computer system in some embodiments. The example system 1000 also includes a package substrate 1004 with an integrated circuit die 1006 attached to the package substrate 1004. The die 1006 may be a packaged or unpacked integrated circuit product that includes one or more integrated circuit dies (e.g., the die 1102 of FIG. 11, the integrated circuit device 1200 of FIG. 12) and/or one or more other suitable components. The die 1006 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the die 1006 can comprise one or more additional active or passive devices such as capacitors, decoupling capacitors, resistors, inductors, fuses, diodes, transformers, sensors, electrostatic discharge (ESD) devices, and memory devices. In addition to comprising one or more processor units, the die 1006 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". The package substrate 1004 may provide electrical connections between the die 1006 and the circuit board 1002.

Similar to the system 1000, the system 1010 also includes a circuit board 1012, which may be implemented as a motherboard or main board of a computer system in some embodiments. The system 1010 also includes a multi-die package 1014, which includes multiple integrated circuits/dies (e.g., 1006), and interconnections between the dies in one or more metallization layers. The multi-die package 1014 may include, for example, one or more silicon interposers, one or more silicon bridges embedded in the package substrate (e.g., an Intel^{®} embedded multi-die interconnect bridge (EMIB)), or combinations thereof.

The main circuit boards 1002, 1012 may provide electrical connections to other components of a computer system, e.g., memory, storage, network interfaces, peripheral devices, power supplies, etc. The main circuit board may include one or more traces and circuit components to provide interconnects between such computer system components.

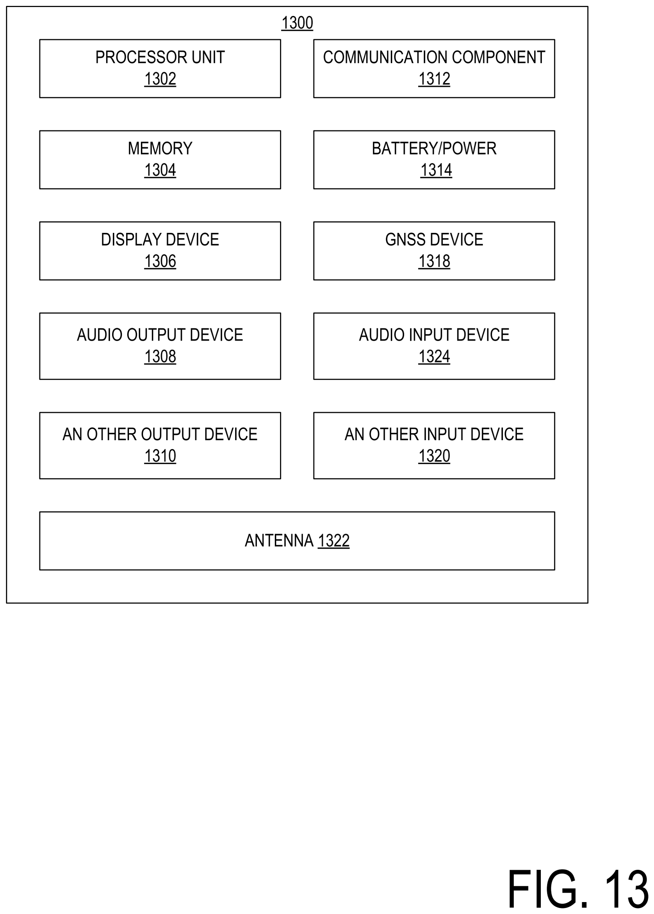

FIG. 11 is a top view of a wafer 1100 and dies 1102 that may be implemented in or along with any of the embodiments disclosed herein. The wafer 1100 may be composed of semiconductor material and may include one or more dies 1102 having integrated circuit structures formed on a surface of the wafer 1100. The individual dies 1102 may be a repeating unit of an integrated circuit product that includes any suitable integrated circuit. After the fabrication of the semiconductor product is complete, the wafer 1100 may undergo a singulation process in which the dies 1102 are separated from one another to provide discrete "chips" of the integrated circuit product. The die 1102 may include one or more transistors (e.g., some of the transistors 1240 of FIG. 12, discussed below), supporting circuitry to route electrical signals to the transistors, passive components (e.g., signal traces, resistors, capacitors, or inductors), and/or any other integrated circuit components. In some embodiments, the wafer 1100 or the die 1102 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1102. For example, a memory array formed by multiple memory devices may be formed on a same die 1102 as a processor unit (e.g., the processor unit 1302 of FIG. 13) or other logic that is configured to store information in the memory devices or execute instructions stored in the memory array.

FIG. 12 is a cross-sectional side view of an integrated circuit device 1200 that may be included in any of the embodiments disclosed herein. One or more of the integrated circuit devices 1200 may be included in one or more dies 1102 (FIG. 11). The integrated circuit device 1200 may be formed on a die substrate 1202 (e.g., the wafer 1100 of FIG. 11) and may be included in a die (e.g., the die 1102 of FIG. 11). The die substrate 1202 may be a semiconductor substrate composed of semiconductor material systems including, for example, n-type or p-type materials systems (or a combination of both). The die substrate 1202 may include, for example, a crystalline substrate formed using a bulk silicon or a silicon-on-insulator (SOI) substructure. In some embodiments, the die substrate 1202 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1202. Although a few examples of materials from which the die substrate 1202 may be formed are described here, any material that may serve as a foundation for an integrated circuit device 1200 may be used. The die substrate 1202 may be part of a singulated die (e.g., the dies 1102 of FIG. 11) or a wafer (e.g., the wafer 1100 of FIG. 11).

The integrated circuit device 1200 may include one or more device layers 1204 disposed on the die substrate 1202. The device layer 1204 may include features of one or more transistors 1240 (e.g., metal oxide semiconductor field-effect transistors (MOSFETs)) formed on the die substrate 1202. The transistors 1240 may include, for example, one or more source and/or drain (S/D) regions 1220, a gate 1222 to control current flow between the S/D regions 1220, and one or more S/D contacts 1224 to route electrical signals to/from the S/D regions 1220. The transistors 1240 may include additional features not depicted for the sake of clarity, such as device isolation regions, gate contacts, and the like. The transistors 1240 are not limited to the type and configuration depicted in FIG. 12 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

Returning to FIG. 12, a transistor 1240 may include a gate 1222 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1240 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1240 along the source-channel-drain direction, the gate electrode may consist of a U-shaped structure that includes a bottom portion substantially parallel to the surface of the die substrate 1202 and two sidewall portions that are substantially perpendicular to the top surface of the die substrate 1202. In other embodiments, at least one of the metal layers that form the gate electrode may simply be a planar layer that is substantially parallel to the top surface of the die substrate 1202 and does not include sidewall portions substantially perpendicular to the top surface of the die substrate 1202. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1220 may be formed within the die substrate 1202 adjacent to the gate 1222 of individual transistors 1240. The S/D regions 1220 may be formed using an implantation/diffusion process or an etching/deposition process, for example. In the former process, dopants such as boron, aluminum, antimony, phosphorous, or arsenic may be ion-implanted into the die substrate 1202 to form the S/D regions 1220. An annealing process that activates the dopants and causes them to diffuse farther into the die substrate 1202 may follow the ion-implantation process. In the latter process, the die substrate 1202 may first be etched to form recesses at the locations of the S/D regions 1220. An epitaxial deposition process may then be carried out to fill the recesses with material that is used to fabricate the S/D regions 1220. In some implementations, the S/D regions 1220 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1220 may be formed using one or more alternate semiconductor materials such as germanium or a group III-V material or alloy. In further embodiments, one or more layers of metal and/or metal alloys may be used to form the S/D regions 1220.

Electrical signals, such as power and/or input/output (I/O) signals, may be routed to and/or from the devices (e.g., transistors 1240) of the device layer 1204 through one or more interconnect layers disposed on the device layer 1204 (illustrated in FIG. 12 as interconnect layers 1206-1210). For example, electrically conductive features of the device layer 1204 (e.g., the gate 1222 and the S/D contacts 1224) may be electrically coupled with the interconnect structures 1228 of the interconnect layers 1206-1210. The one or more interconnect layers 1206-1210 may form a metallization stack (also referred to as an "ILD stack") 1219 of the integrated circuit device 1200.

The interconnect structures 1228 may be arranged within the interconnect layers 1206-1210 to route electrical signals according to a wide variety of designs; in particular, the arrangement is not limited to the particular configuration of interconnect structures 1228 depicted in FIG. 12. Although a particular number of interconnect layers 1206-1210 is depicted in FIG. 12, embodiments of the present disclosure include integrated circuit devices having more or fewer interconnect layers than depicted.

In some embodiments, the interconnect structures 1228 may include lines 1228a and/or vias 1228b filled with an electrically conductive material such as a metal. The lines 1228a may be arranged to route electrical signals in a direction of a plane that is substantially parallel with a surface of the die substrate 1202 upon which the device layer 1204 is formed. For example, the lines 1228a may route electrical signals in a direction in and out of the page and/or in a direction across the page from the perspective of FIG. 12. The vias 1228b may be arranged to route electrical signals in a direction of a plane that is substantially perpendicular to the surface of the die substrate 1202 upon which the device layer 1204 is formed. In some embodiments, the vias 1228b may electrically couple lines 1228a of different interconnect layers 1206-1210 together.

The interconnect layers 1206-1210 may include a dielectric material 1226 disposed between the interconnect structures 1228, as shown in FIG. 12. In some embodiments, dielectric material 1226 disposed between the interconnect structures 1228 in different ones of the interconnect layers 1206-1210 may have different compositions; in other embodiments, the composition of the dielectric material 1226 between different interconnect layers 1206-1210 may be the same. The device layer 1204 may include a dielectric material 1226 disposed between the transistors 1240 and a bottom layer of the metallization stack as well. The dielectric material 1226 included in the device layer 1204 may have a different composition than the dielectric material 1226 included in the interconnect layers 1206-1210; in other embodiments, the composition of the dielectric material 1226 in the device layer 1204 may be the same as a dielectric material 1226 included in any one of the interconnect layers 1206-1210.

A first interconnect layer 1206 (referred to as Metal 1 or "M1") may be formed directly on the device layer 1204. In some embodiments, the first interconnect layer 1206 may include lines 1228a and/or vias 1228b, as shown. The lines 1228a of the first interconnect layer 1206 may be coupled with contacts (e.g., the S/D contacts 1224) of the device layer 1204. The vias 1228b of the first interconnect layer 1206 may be coupled with the lines 1228a of a second interconnect layer 1208.

The second interconnect layer 1208 (referred to as Metal 2 or "M2") may be formed directly on the first interconnect layer 1206. In some embodiments, the second interconnect layer 1208 may include via 1228b to couple the line 1228a of the second interconnect layer 1208 with the lines 1228a of a third interconnect layer 1210. Although the lines 1228a and the vias 1228b are structurally delineated with a line within individual interconnect layers for the sake of clarity, the lines 1228a and the vias 1228b may be structurally and/or materially contiguous (e.g., simultaneously filled during a dual-damascene process) in some embodiments.

The third interconnect layer 1210 (referred to as Metal 3 or "M3") (and additional interconnect layers, as desired) may be formed in succession on the second interconnect layer 1208 according to similar techniques and configurations described in connection with the second interconnect layer 1208 or the first interconnect layer 1206. In some embodiments, the interconnect layers that are "higher up" in the metallization stack 1219 in the integrated circuit device 1200 (i.e., farther away from the device layer 1204) may be thicker that the interconnect layers that are lower in the metallization stack 1219, with lines 1228a and vias 1228b in the higher interconnect layers being thicker than those in the lower interconnect layers.

The integrated circuit device 1200 may include a solder resist material 1234 (e.g., polyimide or similar material) and one or more conductive contacts 1236 formed on the interconnect layers 1206-1210. In FIG. 12, the conductive contacts 1236 are illustrated as taking the form of bond pads. The conductive contacts 1236 may be electrically coupled with the interconnect structures 1228 and configured to route the electrical signals of the transistor(s) 1240 to external devices. For example, solder bonds may be formed on the one or more conductive contacts 1236 to mechanically and/or electrically couple an integrated circuit die including the integrated circuit device 1200 with another component (e.g., a printed circuit board or a package substrate, e.g., 112). The integrated circuit device 1200 may include additional or alternate structures to route the electrical signals from the interconnect layers 1206-1210; for example, the conductive contacts 1236 may include other analogous features (e.g., posts) that route the electrical signals to external components.

In some embodiments in which the integrated circuit device 1200 is a double-sided die, the integrated circuit device 1200 may include another metallization stack (not shown) on the opposite side of the device layer(s) 1204. This metallization stack may include multiple interconnect layers as discussed above with reference to the interconnect layers 1206-1210, to provide conductive pathways (e.g., including conductive lines and vias) between the device layer(s) 1204 and additional conductive contacts (not shown) on the opposite side of the integrated circuit device 1200 from the conductive contacts 1236.

In other embodiments in which the integrated circuit device 1200 is a double-sided die, the integrated circuit device 1200 may include one or more through silicon vias (TSVs) through the die substrate 1202; these TSVs may make contact with the device layer(s) 1204, and may provide conductive pathways between the device layer(s) 1204 and additional conductive contacts (not shown) on the opposite side of the integrated circuit device 1200 from the conductive contacts 1236. In some embodiments, TSVs extending through the substrate can be used for routing power and ground signals from conductive contacts on the opposite side of the integrated circuit device 1200 from the conductive contacts 1236 to the transistors 1240 and any other components integrated into the die, and the metallization stack 1219 can be used to route I/O signals from the conductive contacts 1236 to transistors 1240 and any other components integrated into the die.

Multiple integrated circuit devices 1200 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

FIG. 13 is a block diagram of an example electrical device 1300 that may include one or more of the embodiments disclosed herein. For example, any suitable ones of the components of the electrical device 1300 may include one or more of integrated circuit devices 1200, or integrated circuit dies 1102 disclosed herein. A number of components are illustrated in FIG. 13 as included in the electrical device 1300, but any one or more of these components may be omitted or duplicated, as suitable for the application. In some embodiments, some or all of the components included in the electrical device 1300 may be attached to one or more motherboards mainboards, or system boards. In some embodiments, one or more of these components are fabricated onto a single system-on-a-chip (SoC) die.

Additionally, in various embodiments, the electrical device 1300 may not include one or more of the components illustrated in FIG. 13, but the electrical device 1300 may include interface circuitry for coupling to the one or more components. For example, the electrical device 1300 may not include a display device 1306, but may include display device interface circuitry (e.g., a connector and driver circuitry) to which a display device 1306 may be coupled. In another set of examples, the electrical device 1300 may not include an audio input device 1324 or an audio output device 1308, but may include audio input or output device interface circuitry (e.g., connectors and supporting circuitry) to which an audio input device 1324 or audio output device 1308 may be coupled.

The electrical device 1300 may include one or more processor units 1302 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1302 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1300 may include a memory 1304, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1304 may include memory that is located on the same integrated circuit die as the processor unit 1302. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1300 can comprise one or more processor units 1302 that are heterogeneous or asymmetric to another processor unit 1302 in the electrical device 1300. There can be a variety of differences between the processing units 1302 in a system in terms of a spectrum of metrics of merit including architectural, microarchitectural, thermal, power consumption characteristics, and the like. These differences can effectively manifest themselves as asymmetry and heterogeneity among the processor units 1302 in the electrical device 1300.

In some embodiments, the electrical device 1300 may include a communication component 1312 (e.g., one or more communication components). For example, the communication component 1312 can manage wireless communications for the transfer of data to and from the electrical device 1300. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1312 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1312 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1312 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1312 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1312 may operate in accordance with other wireless protocols in other embodiments. The electrical device 1300 may include an antenna 1322 to facilitate wireless communications and/or to receive other wireless communications (such as AM or FM radio transmissions).

In some embodiments, the communication component 1312 may manage wired communications, such as electrical, optical, or any other suitable communication protocols (e.g., IEEE 802.3 Ethernet standards). As noted above, the communication component 1312 may include multiple communication components. For instance, a first communication component 1312 may be dedicated to shorter-range wireless communications such as Wi-Fi or Bluetooth, and a second communication component 1312 may be dedicated to longer-range wireless communications such as global positioning system (GPS), EDGE, GPRS, CDMA, WiMAX, LTE, EV-DO, or others. In some embodiments, a first communication component 1312 may be dedicated to wireless communications, and a second communication component 1312 may be dedicated to wired communications.

The electrical device 1300 may include battery/power circuitry 1314. The battery/power circuitry 1314 may include one or more energy storage devices (e.g., batteries or capacitors) and/or circuitry for coupling components of the electrical device 1300 to an energy source separate from the electrical device 1300 (e.g., AC line power).

The electrical device 1300 may include a display device 1306 (or corresponding interface circuitry, as discussed above). The display device 1306 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1300 may include an audio output device 1308 (or corresponding interface circuitry, as discussed above). The audio output device 1308 may include any embedded or wired or wirelessly connected external device that generates an audible indicator, such speakers, headsets, or earbuds.

The electrical device 1300 may include an audio input device 1324 (or corresponding interface circuitry, as discussed above). The audio input device 1324 may include any embedded or wired or wirelessly connected device that generates a signal representative of a sound, such as microphones, microphone arrays, or digital instruments (e.g., instruments having a musical instrument digital interface (MIDI) output). The electrical device 1300 may include a Global Navigation Satellite System (GNSS) device 1318 (or corresponding interface circuitry, as discussed above), such as a Global Positioning System (GPS) device. The GNSS device 1318 may be in communication with a satellite-based system and may determine a geolocation of the electrical device 1300 based on information received from one or more GNSS satellites, as known in the art.

The electrical device 1300 may include another output device 1310 (or corresponding interface circuitry, as discussed above). Examples of the other output device 1310 may include an audio codec, a video codec, a printer, a wired or wireless transmitter for providing information to other devices, or an additional storage device.

The electrical device 1300 may include another input device 1320 (or corresponding interface circuitry, as discussed above). Examples of the other input device 1320 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photo plethysmogram) sensor, galvanic skin response sensor, any other sensor, or a radio frequency identification (RFID) reader.

The electrical device 1300 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1300 may be any other electronic device that processes data. In some embodiments, the electrical device 1300 may comprise multiple discrete physical components. Given the range of devices that the electrical device 1300 can be manifested as in various embodiments, in some embodiments, the electrical device 1300 can be referred to as a computing device or a computing system.

In the above description, various aspects of the illustrative implementations have been described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials, and configurations have been set forth to provide a thorough understanding of the illustrative implementations. However, it will be apparent to one skilled in the art that the present disclosure may be practiced without all of the specific details. In other instances, well-known features have been omitted or simplified in order not to obscure the illustrative implementations.

Further, concepts described herein are illustrated by way of example and not by way of limitation in the accompanying figures. It will be understood that in the examples shown and described further below, the figures may not be drawn to scale and may not include all possible layers and/or circuit components. In addition, it will be understood that although certain figures illustrate transistor designs with source/drain regions, electrodes, etc. having orthogonal (e.g., perpendicular) boundaries, embodiments herein may implement such boundaries in a substantially orthogonal manner (e.g., within +/- 5 or 10 degrees of orthogonality) due to fabrication methods used to create such devices or for other reasons. Where considered appropriate, reference labels may have been repeated between certain Figures to indicate corresponding or analogous elements.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C). For the purposes of the present disclosure, the phrase "A and at least one of B and C" means (A and B), (A and C), or (A and B and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components. As used herein, the term "adjacent" refers to layers or components that are in physical contact with each other. That is, there is no layer or component between the stated adjacent layers or components. For example, a layer X that is adjacent to a layer Y refers to a layer that is in physical contact with layer Y.

The above description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 is an apparatus comprising: a glass layer comprising a hole between a first side of the glass layer and a second side of the glass layer opposite the first side; a conductive via in the glass layer electrically coupling the first side of the glass layer and the second side of the glass layer; and a polymer layer between the glass layer and the conductive via.

Example 2 includes the apparatus of Example 1, further comprising an intermediate layer between the glass layer and the polymer layer.

Example 3 includes the apparatus of Example 2, wherein the intermediate layer is in contact with inner surfaces of the hole of the glass layer and the polymer layer is in contact with the via.

Example 4 includes the apparatus of Example 2 or 3, wherein the intermediate layer is conductive and comprises copper or silver.

Example 5 includes the apparatus of Example 2 or 3, wherein the intermediate layer is dielectric and comprises oxygen and one or more of aluminum, zinc, and titanium.

Example 6 includes the apparatus of Example 2 or 3, wherein the intermediate layer is dielectric and comprises nitrogen and aluminum.

Example 7 includes the apparatus of any one of Examples 1-6, wherein the polymer layer comprises a thiophene-based polymer, a pyrrole-based polymer, or an aniline-based polymer.

Example 8 includes the apparatus of any one of Examples 1-7, wherein the polymer layer comprises one of polypyrrole, polythiophene, polyaniline, PEDOT (poly(3,4-ehtylenedioxythiophene)), polystyrene sulfonate (PSS), polyamine.

Example 9 includes the apparatus of any one of Examples 1-8, wherein the conductive via is not in direct contact with the glass layer.

Example 10 includes the apparatus of any one of Examples 1-9, further comprising first buildup layers above the glass layer and second buildup layers below the glass layer, wherein a metal trace in the first buildup layers is connected to a metal trace in the second buildup layers by the conductive via.

Example 11 includes the apparatus of Example 10, further comprising an integrated circuit die, conductive contacts of the integrated circuit die connected to the metal trace in the first buildup layers.

Example 12 includes the apparatus of any one of Examples 1-11, wherein the glass layer comprises silicon at least 23% by weight and oxygen at least 26% by weight.

Example 13 is an apparatus comprising: a package substrate comprising: glass core layer; a through glass via (TGV) in the glass core layer; a polymer layer between the TGV and the glass core layer; and buildup layers on the glass core layer, the buildup layers comprising metal traces connected to the TGV.

Example 14 includes the apparatus of Example 13, further comprising an intermediate layer between the glass core layer and the polymer layer.

Example 15 includes the apparatus of Example 14, wherein the intermediate layer is in contact with the glass core layer and the polymer layer is in contact with the TGV.

Example 16 includes the apparatus of Example 14 or 15, wherein the intermediate layer is conductive and comprises copper or silver.

Example 17 includes the apparatus of Example 14 or 15, wherein the intermediate layer is dielectric and comprises oxygen and one or more of aluminum, zinc, and titanium.

Example 18 includes the apparatus of Example 14 or 15, wherein the intermediate layer is dielectric and comprises nitrogen and aluminum.

Example 19 includes the apparatus of any one of Examples 13-18, wherein the polymer layer comprises a thiophene-based polymer, a pyrrole-based polymer, or an aniline-based polymer.

Example 20 includes the apparatus of any one of Examples 13-19, wherein the polymer layer comprises one of polypyrrole, polythiophene, polyaniline, PEDOT (poly(3,4-ehtylenedioxythiophene)), polystyrene sulfonate (PSS), polyamine.

Example 21 includes the apparatus of any one of Examples 13-20, wherein the TGV is not in direct contact with the glass core layer.

Example 22 includes the apparatus of any one of Examples 13-21, wherein the glass core layer comprises silicon at least 23% by weight and oxygen at least 26% by weight.

Example 23 includes the apparatus of any one of Examples 13-22, further comprising an integrated circuit die coupled to the package substrate.

Example 24 is a system comprising: an integrated circuit die; and a package substrate coupled to the integrated circuit die, the package substrate comprising: a glass core layer; a plurality of through glass vias (TGVs) in the glass core layer; and a polymer layer between each TGV and the glass core layer.

Example 25 includes the system of Example 24, further comprising an intermediate layer between the glass core layer and the polymer layer.

Example 26 includes the system of Example 25, wherein the intermediate layer is in contact with the glass core layer and the polymer layer is in contact with the TGV.

Example 27 includes the system of Example 25 or 26, wherein the intermediate layer is conductive and comprises copper or silver.

Example 28 includes the system of Example 25 or 26, wherein the intermediate layer is dielectric and comprises oxygen and one or more of aluminum, zinc, and titanium.

Example 29 includes the system of Example 25 or 26, wherein the intermediate layer is dielectric and comprises nitrogen and aluminum.

Example 30 includes the system of any one of Examples 24-29, wherein the polymer layer comprises a thiophene-based polymer, a pyrrole-based polymer, or an aniline-based polymer.

Example 31 includes the system of any one of Examples 24-30, wherein the polymer layer comprises one of polypyrrole, polythiophene, polyaniline, PEDOT (poly(3,4-ehtylenedioxythiophene)), polystyrene sulfonate (PSS), polyamine.

Example 32 includes the system of any one of Examples 24-31, wherein the TGVs are not in direct contact with the glass core layer.

Example 33 includes the system of any one of Examples 24-32, wherein the glass core layer comprises silicon at least 23% by weight and oxygen at least 26% by weight

Example 34 includes the system of any one of Examples 24-33, wherein the integrated circuit die comprises a processor and the system further comprises a circuit board coupled to the package substrate.

Example 35 is a method comprising: forming a hole in a glass layer; forming an adhesion layer on an inner surface of the hole; forming a polymer layer on the adhesion layer; filling the hole with metal; and forming buildup layers on the glass layer, the buildup layers comprising a plurality of traces and conductive vias, at least one trace of the buildup layers electrically coupled to the metal in the hole.

Example 36 includes the method of Example 35, wherein the adhesion layer comprises a metal and the polymer layer is formed using electroplating.

Example 37 includes the method of Example 36, wherein the polymer layer comprises a conductive polymer.

Example 38 includes the method of Example 37, wherein the polymer layer comprises one or more of polypyrrole, polythiophene, and polyaniline.

Example 39 includes the method of Example 35, wherein the adhesion layer comprises a metal and the polymer layer is formed using chemical vapor deposition (CVD).

Example 40 includes the method of Example 39, wherein the polymer layer comprises poly(3,4-ehtylenedioxythiophene) and polystyrene sulfonate (PEDOT:PSS).

Example 41 includes the method of Example 35, wherein the adhesion layer comprises a metal and the polymer layer is formed using electro-polymerization of conjugated polymers.

Example 42 includes the method of any one of Examples 35-41, wherein the adhesion layer is formed via atomic layer deposition (ALD).

Example 43 is a method comprising: forming a hole in a glass layer; forming a polymer layer on an inner surface of the hole; filling the hole with metal; and forming buildup layers on the glass layer, the buildup layers comprising a plurality of traces and conductive vias, at least one trace of the buildup layers electrically coupled to the metal in the hole.

Example 44 includes the method of Example 43, wherein the polymer layer is formed using molecular layer deposition (MLD).

Example 45 includes the method of Example 43 or 44, wherein forming the polymer layer comprises depositing a monomer in the presence of an oxidizer.

Example 46 includes the method of Example 45, wherein the monomer comprises 3,4-ethylenedioxythiophene (EDT) and the oxidizer comprises chlorine and at least one of molybdenum, rhenium, and antimony.

Example 47 includes the method of Example 43, wherein forming the polymer layer comprises: depositing a conductive polymer on the inner surface of the hole; applying a permanganate treatment to the cationic polymer; and depositing a monomer on the cationic polymer.

Example 48 includes the method of Example 47, wherein the conductive polymer is polyamine, the monomer is 3,4-ethylenedioxythiophene (EDT), and the EDT is deposited in the presence of polystyrene sulfonate (PSS).

Example 49 includes the method of any one of Examples 43-48, wherein the polymer layer comprises poly(3,4-ehtylenedioxythiophene) (PEDOT).

Example 50 includes the method of Example 49, wherein the polymer layer further comprises polystyrene sulfonate (PSS).

Example 51 is a product formed by the method of any one of Examples 35-50.

## Claims

1. An apparatus comprising:
a glass layer comprising a hole between a first side of the glass layer and a second side of the glass layer opposite the first side;
a conductive via in the glass layer electrically coupling the first side of the glass layer and the second side of the glass layer; and
a polymer layer between the glass layer and the conductive via.

2. The apparatus of claim 1, further comprising an intermediate layer between the glass layer and the polymer layer.

3. The apparatus of claim 2, wherein the intermediate layer is in contact with inner surfaces of the hole of the glass layer and the polymer layer is in contact with the via.

4. The apparatus of claim 2 or 3, wherein the intermediate layer is conductive and comprises copper or silver.

5. The apparatus of claim 2 or 3, wherein the intermediate layer is dielectric and comprises oxygen and one or more of aluminum, zinc, and titanium.

6. The apparatus of claim 2 or 3, wherein the intermediate layer is dielectric and comprises nitrogen and aluminum.

7. The apparatus of any one of claims 1-6, wherein the polymer layer comprises a thiophene-based polymer, a pyrrole-based polymer, or an aniline-based polymer.

8. The apparatus of any one of claims 1-7, wherein the polymer layer comprises one of polypyrrole, polythiophene, polyaniline, PEDOT (poly(3,4-ehtylenedioxythiophene)), polystyrene sulfonate (PSS), polyamine.

9. The apparatus of any one of claims 1-8, wherein the conductive via is not in direct contact with the glass layer.

10. The apparatus of any one of claims 1-9, wherein the glass layer is amorphous.

11. The apparatus of any one of claims 1-10, wherein the glass layer comprises silicon at least 23% by weight and oxygen at least 26% by weight.

12. The apparatus of any one of claims 1-11, further comprising first buildup layers above the glass layer and second buildup layers below the glass layer, wherein a metal trace in the first buildup layers is connected to a metal trace in the second buildup layers by the conductive via.

13. A system comprising:
an integrated circuit die; and
a package substrate coupled to the integrated circuit die, the package substrate comprising the apparatus of any one of claims 1-12.

14. The system of claim 13, wherein conductive contacts of the integrated circuit die are connected to metal traces in buildup layers of the package substrate.

15. The system of claim 13 or 14, wherein the integrated circuit die comprises a processor and the system further comprises a circuit board coupled to the package substrate.
